# EUROPEAN PATENT APPLICATION

(11) **EP 2 779 212 A2**
(43) Date of publication of application: **17.09.2014**
(21) Application number: 14159907.6
(22) Date of filing: 14.03.2014
(51) Int. Cl.: H01L 21/18, H01L 21/02

(54) **Method of forming a high electron mobility semiconductor device**

(30) Priority: 15.03.2013 US 201361786577 P
(71) Applicant: Semiconductor Components Industries, LLC, Phoenix, AZ 85008 (US)
(72) Inventor: Salih, Ali, Mesa, AZ 85213 (US); Parsey, Jr, John, Phoenix, AZ 85048 (US)
(74) Representative: Clarke, Geoffrey Howard

(57) **Abstract**

In an embodiment, a semiconductor device is formed by a method that includes, providing a base substrate of a first semiconductor material, and forming a layer that is one of SiC or a III-V series material on the base substrate. In a different embodiment, the base substrate may be one of silicon, porous silicon, or porous silicon with nucleation sites formed thereon, or silicon in a (111) plane.

## Description

The present invention relates, in general, to electronics, and more particularly, to semiconductors, structures thereof, and methods of forming semiconductor devices.

In the past, the semiconductor industry utilized various methods to form semiconductor devices that used III series semiconductor materials such as gallium nitride (GaN) as one of the semiconductor materials. The devices typically were formed on a GaN substrate. However, GaN was expensive which resulted in a high cost for the semiconductor devices.

It is an object of the present invention to overcome at least some of the disadvantages of the prior art.

Accordingly, it is desirable to have a semiconductor device using GaN or other III-V series and/or II-VI series material such as a III-nitride series material that has a lower cost.

According to one aspect of the present invention there is provided a method of forming a HEM semiconductor device comprising providing a base substrate of a first semiconductor material that includes silicon; and forming a layer that is one of GaN or SiC or other III-N or III-V or II-VI series material on the base substrate.

According to another aspect of the present invention there is provided a HEM device comprising a silicon base substrate having a surface in a (111) plane; and a layer of GaN or other II-V or II-VI material on the surface of the silicon base substrate wherein the layer is formed with a (0001) plane on the (111) plane of the silicon base substrate.

The invention will now be described with reference to the accompanying figures in which:
FIG. 1 schematically illustrates an example of an embodiment of a crystalline structure that may be useful in forming GaN in accordance with the present invention;
FIG. 2 schematically illustrates an example of an embodiment of a crystal structure of GaN and silicon in accordance with the present invention;
FIG. 3-FIG. 5 illustrates various stages in portions of an example of an embodiment of a method of forming a GaN or SiC semiconductor device or other III-V or II-VI series semiconductor device in accordance with the present invention;
FIG. 6 illustrates various images of nano-porous silicon in accordance with the present invention;
FIG. 7-FIG. 12 illustrate various stages in portions of examples of embodiments of methods of forming HEM device including a GaN or SiC semiconductor device or other III-V or II-VI series semiconductor devices in accordance with the present invention;
FIG. 13-FIG. 15 illustrate various stages in portions of an example of another embodiment of a method of forming HEM device including a GaN or SiC semiconductor device or other III-V or II-VI series semiconductor device in accordance with the present invention;
FIG. 16-FIG. 19 illustrate various stages in portions of an example of an alternate embodiment of a method of forming HEM device including a GaN or SiC semiconductor device or other III-V or II-VI series semiconductor device in accordance with the present invention;
FIG. 20-FIG. 21 illustrate various stages in portions of an example of another alternate embodiment of a method of forming HEM device including a GaN or SiC semiconductor device or other III-V or II-VI series semiconductor device in accordance with the present invention;
FIG. 22-FIG. 24 illustrate various stages in portions of an example of another alternate embodiment of a method of forming a HEM device including a GaN or SiC semiconductor device or other III-V or II-VI series semiconductor device in accordance with the present invention;
FIG. 25 illustrates another alternate embodiment of a method of forming a HEM device including a GaN or SiC semiconductor device or other III-V or II-VI series semiconductor device in accordance with the present invention;
FIG. 26-FIG. 28 illustrate various stages in portions of an example of another alternate embodiment of a method of forming a HEM device including a GaN or SiC semiconductor device or other III-V or II-VI series semiconductor device in accordance with the present invention; and
FIG. 29-FIG. 31 illustrate various stages in portions of an example of another alternate embodiment of a method of forming a HEM device including a GaN or SiC semiconductor device or other III-V or II-VI series semiconductor device in accordance with the present invention.

For simplicity and clarity of the illustration(s), elements in the figures are not necessarily to scale, and the same reference numbers in different figures denote the same elements, unless stated otherwise. Additionally, descriptions and details of well-known steps and elements are omitted for simplicity of the description. As used herein current carrying electrode or current carrying element means an element of a device that carries current through the device such as a source or a drain of an MOS transistor or an emitter or a collector of a bipolar transistor or a cathode or anode of a diode, and a control electrode means an element of the device that controls current through the device such as a gate of an MOS transistor or a base of a bipolar transistor. Although the devices are explained herein as certain N-channel or P-Channel devices, or certain N-type or P-type doped regions, a person of ordinary skill in the art will appreciate that complementary devices are also possible in accordance with the present invention. One of ordinary skill in the art understands that the conductivity type refers to the mechanism through which conduction occurs such as through conduction of holes or electrons, therefore, and that conductivity type does not refer to the doping concentration but the doping type, such as P-type or N-type. It will be appreciated by those skilled in the art that the words during, while, and when as used herein relating to circuit operation are not exact terms that mean an action takes place instantly upon an initiating action but that there may be some small but reasonable delay(s), such as various propagation delays, between the reaction that is initiated by the initial action. Additionally, the term while means that a certain action occurs at least within some portion of a duration of the initiating action. The use of the word approximately or substantially means that a value of an element has a parameter that is expected to be close to a stated value or position. However, as is well known in the art there are always minor variances that prevent the values or positions from being exactly as stated. It is well established in the art that variances of up to at least ten per cent (10%) (and up to twenty per cent (20%) for semiconductor doping concentrations) are reasonable variances from the ideal goal of exactly as described. The terms first, second, third and the like in the claims or/and in the Detailed Description of the Drawings, as used in a portion of a name of an element are used for distinguishing between similar elements and not necessarily for describing a sequence, either temporally, spatially, in ranking or in any other manner. It is to be understood that the terms so used are interchangeable under appropriate circumstances and that the embodiments described herein are capable of operation in other sequences than described or illustrated herein. For clarity of the drawings, doped regions of device structures are illustrated as having generally straight line edges and precise angular corners. However, those skilled in the art understand that due to the diffusion and activation of dopants the edges of doped regions generally may not be straight lines and the corners may not be precise angles.

In addition, the description may illustrate a cellular design (where the body regions are a plurality of cellular regions) instead of a single body design (where the body region is comprised of a single region formed in an elongated pattern, typically in a serpentine pattern). However, it is intended that the description is applicable to both a cellular implementation and a single base implementation.

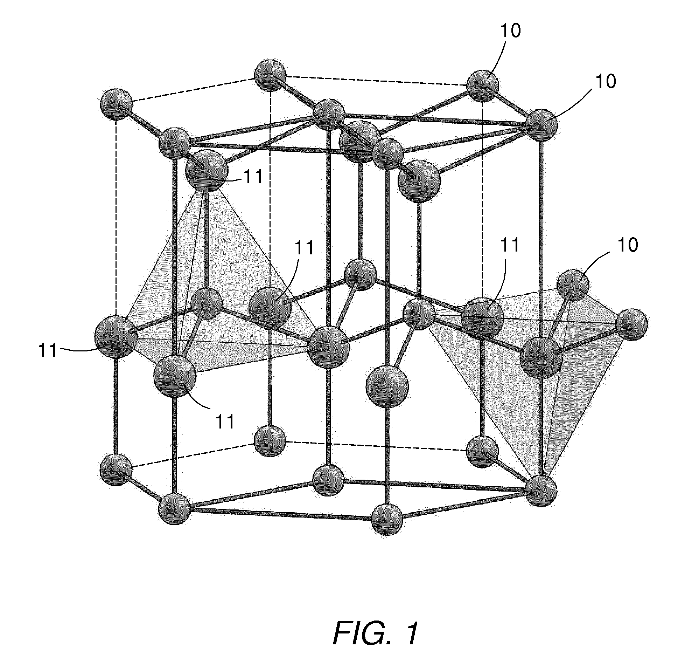

FIG. 1 schematically illustrates an example of an embodiment of a crystalline structure that may be useful in forming GaN. The crystalline structure may be referred to as a Wurtzite structure. An example of a GaN structure is illustrated that includes Gallium (Ga) atoms 10 and nitrogen atoms 11. There is believed to be a mismatch between the crystalline structures of GaN and Si. It is believed that GaN has a smaller lattice constant than Si. For example, there may be around a seventeen percent (17%) lattice mismatch between GaN (0001) basal plane on Si (111). There is also believed to be around a 24% thermal expansion mismatch between Si and GaN. Also, the GaN lattice constant (hexagonal basal plane) is smaller than that of Si (111), causing GaN epitaxy stress to be tensile. Such differences could result in high defect densities when forming GaN on Si. Defect densities could be in the range of approximately 10⁸ to 10¹⁰ cm⁻². Lattice mismatch stress causes misfit dislocations and possibly about 10⁹ cm⁻² threading dislocation densities. This stress could result in cracking of the GaN film or slip or cracking of the silicon substrate. As will be seen further hereinafter, in one example embodiment a method of forming semiconductors having III-V or II-VI material as a portion of the device may include forming the materials on a silicon substrate which reduces the manufacturing costs of the semiconductor device. As will be seen hereinafter, at least one example method uses (100) silicon to form a layer of III-V or II-VI series material. Other embodiments may use (111) silicon or off-orientation silicon or other semiconductor or dielectric substrates.

This lattice mismatch stress should not be confused with the good AlGaN/GaN lattice strain. This good stress-coupled with energy gap discontinuity (ΔE_{c}) provides the piezoelectric effect which is responsible for the two dimensional electron gas (2DEG) and superb conductivity of AlGaN/GaN high electron mobility (HEM) transistors (HEMTs).

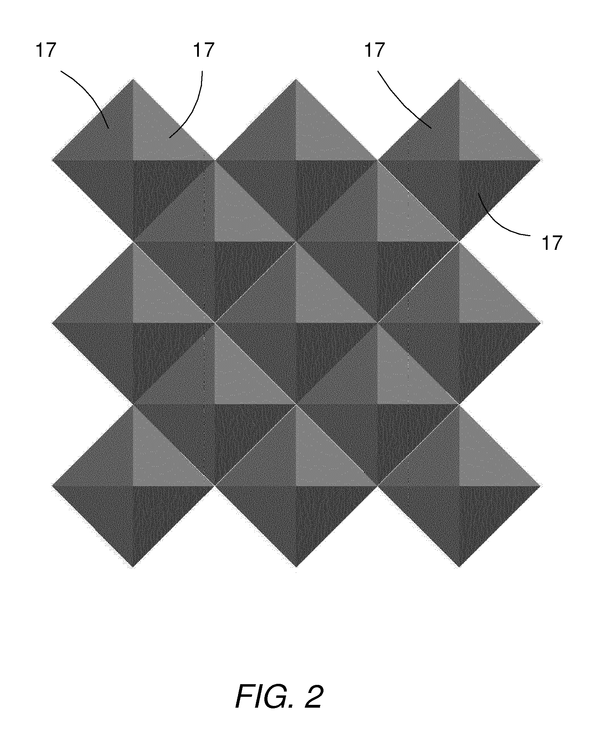

FIG. 2 schematically illustrates an example of an embodiment of a crystal structure of silicon epitaxy. The view illustrates silicon (111) planes 17 in a cubic crystal structure view from the (100) plane. The (111) planes 17 project from the (100) surface as illustrated. In one example embodiment, a substrate may be preferentially etched exposing specific surface planes such as {111}, {112}, {110} and the like, and using the desired plane to grow heterogeneous epitaxy with reduced lattice and thermal expansion mismatches.

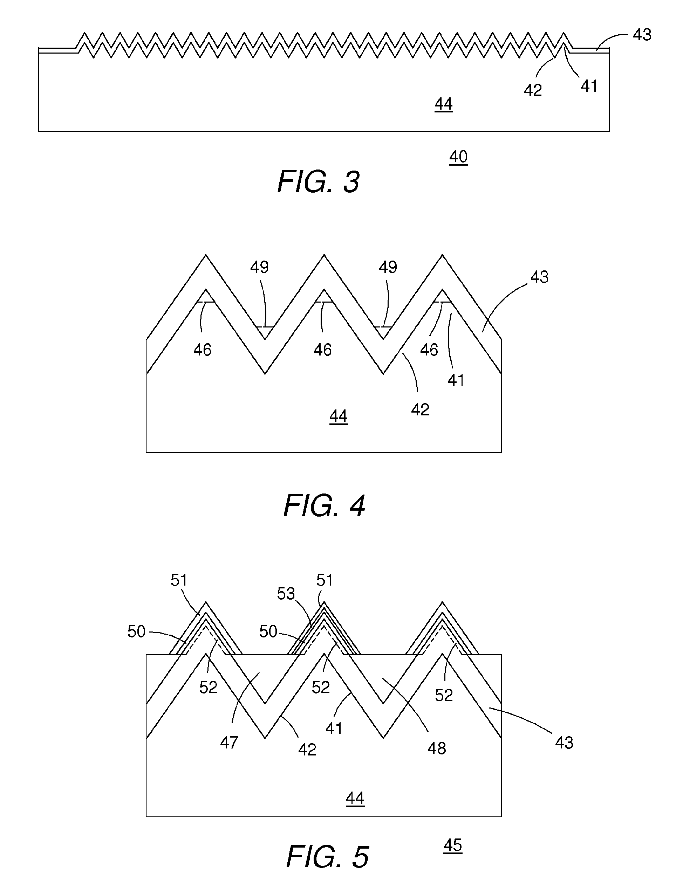

FIG. 3-FIG. 5 illustrates various stages in portions of an example of an embodiment of a method of forming a high electron mobility (HEM) device such as for example a GaN or SiC semiconductor device or other III-V or II-VI series semiconductor device. The semiconductor device may be a transistor or diode or other HEM device.

FIG. 3 illustrates a reduced cross-sectional view of a portion of an example of an embodiment of a semiconductor wafer 40 that includes a silicon substrate 44 that is formed to have a surface in the (100) plane. Substrate 44 may be a bulk substrate or may be a silicon layer that is formed on a bulk substrate, for example, may be an epitaxial layer formed on a bulk silicon substrate or a glass ceramic or other bulk substrate. In one embodiment, substrate 44 is formed to expose the sidewall surfaces of the (111) planes such as surfaces 41 and 42. Surfaces 41 and 42 may be exposed by etching the surface of the substrate (100) plane. Those skilled in the art understand that the (100) surface etches faster in the <111> direction that in the <100> direction such that the <111> direction forms the sidewalls such as illustrated by surface 41 and 42. Surfaces 41 and 42 that may be similar to planes 17 illustrated in FIG. 2. For example, the substrate may be anisotropically etched.

FIG. 4 illustrates a larger view of a portion of substrate 44 and layer 43.

A high electron mobility (HEM) structure or layer 43 of GaN or SiC or other III-V or II-VI series material may be formed on the (111) surface of substrate 44. Typically, layer 43 (and the material thereof) may be formed as an epitaxial layer. In some embodiments, the peaks of the (111) plane formed by surfaces 41 and 42 may be flattened as illustrated by dashed lines 46. The valleys may be flattened by filling or other techniques as illustrated by dashed lines 49. The valley flattening may be formed by epitaxial or CVD or other techniques. The valley flattening may also be formed by etch cessation before reaching the acute bottom angle. The flatter surfaces facilitate more reliable formation of layer 43 such as for example forming a more consistent thickness for layer 43. The peaks may be removed by a planarizing technique such as for example chemical-mechanical polishing (CMP) or other well-known planarizing operations.

FIG. 5 illustrates a subsequent stage of forming a HEM device 45 on substrate 44. A 2DEG channel 52 may be formed in at least a portion of the GaN or SiC or other III-N or II-V or II-VI series material of at least a portion of layer 43. In an embodiment, a source electrode 47 and a drain electrode 48 may be formed on portions of layer 43 that are on alternate faces of the (111) planes such as for example surfaces 41 and 42. In one embodiment, electrodes 47 and 48 may be formed in the valleys of layer 43 that overlie the valleys of surfaces 41 and 42. For example, a conductor material may be used to form electrodes 47 and 48. An embodiment may include forming another material on portions of layer 43 to form a 2DEG channel 52 (illustrated in a general manner by dashed lines) for device 45. An embodiment may include forming a channel-forming material 50 on layer 43. For example, a layer of aluminum gallium nitride (AlGaN) may be formed on a portion of layer 43 that is adjacent to electrodes 47 and/or 48. Material 50 may be any material that assists in forming the 2DEG, such as for example AlGaN, InGaN, or other III-V or II-VI binary, tertiary, or quaternary alloy compound semiconductor or materials such as crystalline Ga₂O₃ and similar materials. In one embodiment, material 50 may be formed on a portion of the surface of layer 43 that overlies the peaks of or the flattened top portions of and/or adjacent portions of the surface of surfaces 41 and 42. Material 50 may be formed prior to or subsequently to the material for electrodes 47 and 48. For the embodiment of a HEM transistor, a gate electrode 51 may be formed on or overlying a portion of material 50. An embodiment may include forming material 51 as a conductor material. An optional gate insulator 53 may be formed between material 50 and the gate electrode such as a portion of material 51. Insulator 53 may be HfO₂, SiO₂, Al₂O₃, or other well-known insulator material. The method facilitates increasing the total surface area used for a HEM semiconductor device per unit area of the substrate thereby reducing the costs.

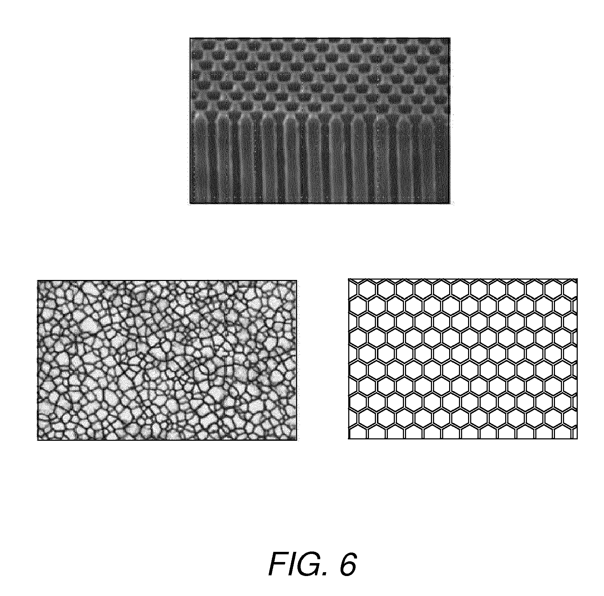

FIG. 6 illustrates various images of various types of porous and/or nano-porous silicon. For example, a silicon substrate may include a surface having pores or nano-pores on the surface such as for example the pores illustrated in FIG. 6. The pores may have openings with a diameter that ranges from less than approximately two nanometers (2 nm) to a diameter of approximately one thousand nanometers (1000 nm) or a variety of sizes. Another embodiment of a method of forming a HEM device may include using a silicon substrate having a porous silicon and/or nano-porous silicon surface. The pores of the porous surface may be formed by a variety of methods including etching the surface with acid(s) or other etching materials or by laser ablation of the surface. An embodiment may include using a mask to protect portions of the surface of the substrate and forming the pores only on exposed portions of the surface of the substrate.

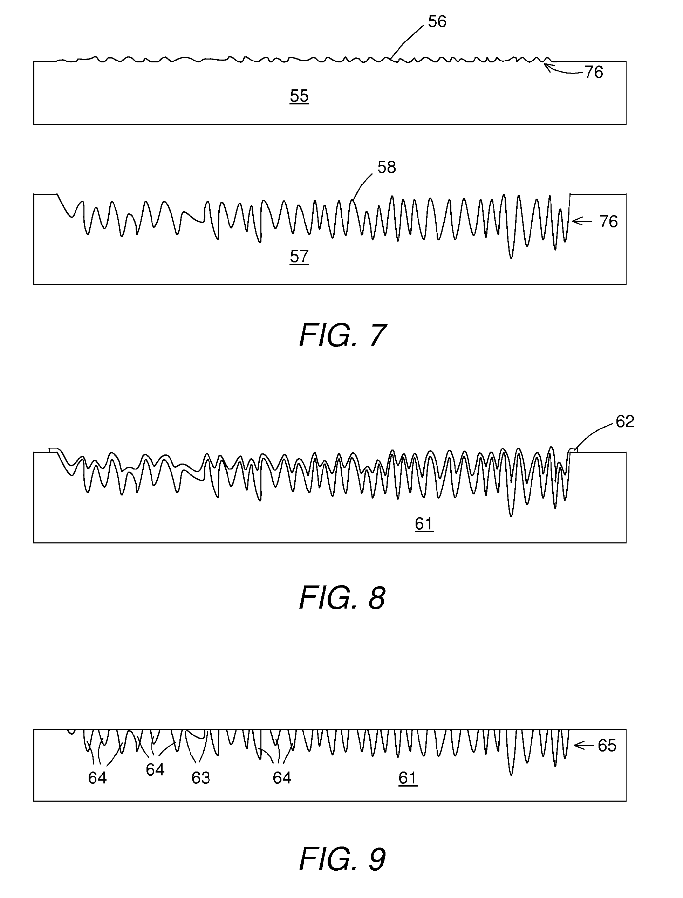

FIG. 7-FIG. 12 illustrate various stages in portions of examples of embodiments of methods of forming a HEM device that includes a GaN or SiC or other III-N series or III-V series or II-VI series semiconductor material. An embodiment of the method may include forming of a crystalline region or crystalline regions interspersed with an insulator and/or oxide to facilitate growth of GaN and/or SiC or other III-N series or III-V series or II-VI series semiconductor material on silicon.

FIG. 7 illustrates a reduced cross-sectional view of an example of a portion of an embodiment of two silicon substrates 55 and 57 that may be formed to have pores on at least a portion of a surface of substrates 55 and 57 thereby forming a porous surface region or porous surface 56 and 58 respectively. Substrates 55 and 57 may each be a bulk substrate or may be a silicon layer that is formed on a bulk substrate. For example, may be an epitaxial layer formed on a bulk silicon substrate or a glass or ceramic or other bulk substrate. The depth of the pores and the diameter of the openings may vary as explained in the description of FIG. 6 and as illustrated by different relative pores of surfaces 56 and 58. The pores may be formed on the (111) or (100) plane or other planes of substrates 55 and/or 57 to form a porous surface or a porous region 76 of the surface of substrates 55 and/or 57.

Referring to FIG. 8, an insulator layer 62 is formed on the surface of one of substrates 55 or 57 to form a substrate 61. In an embodiment, layer 62 may be a layer of silicon dioxide that is formed by oxidizing the porous surface of substrates 55 and/or 57. In other embodiments, other insulators, such as for example Si₃N₄ or AlN, may also be used instead of or in addition to silicon dioxide.

FIG. 9 illustrates substrate 61 at an example of another step in the example of the method. The surface of the substrate 61 may be substantially planarized such as by chemical mechanical polishing (CMP) or other planarization techniques to expose nucleation sites. For example, the nucleation sites may include that the surface of substrate 61 includes insulator regions 64 interspersed with semiconductor regions 63. The width of insulator regions 64 is formed by the size of the pores in surface 56 or 58 that was previously formed. The nucleation sites formed by interspersed silicon and insulator regions, such as for example regions 63 and 64, form a nucleation region 65 on the surface of substrate 61.

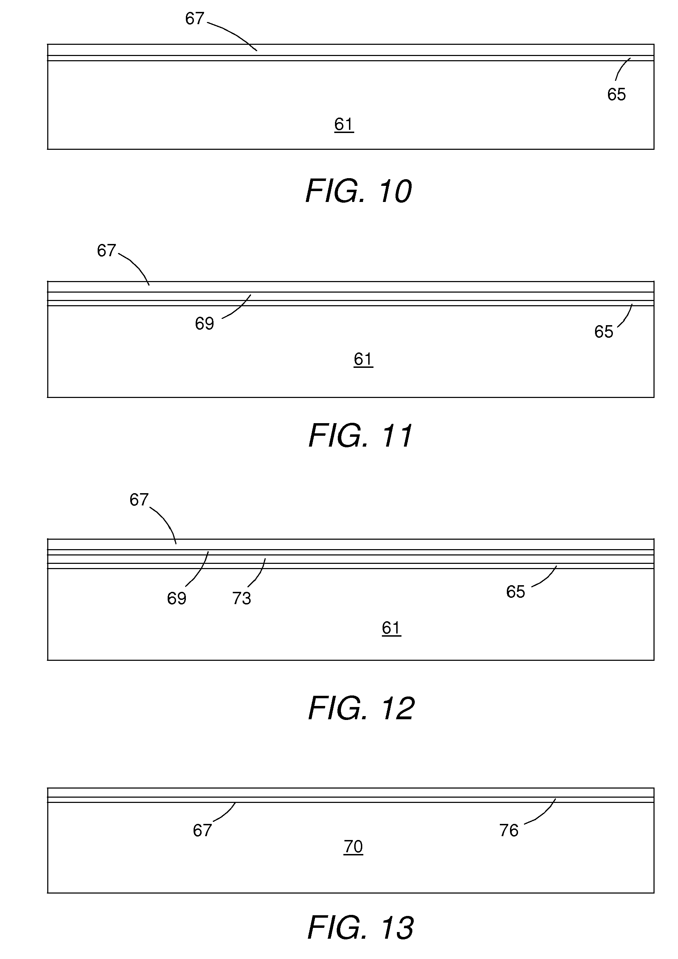

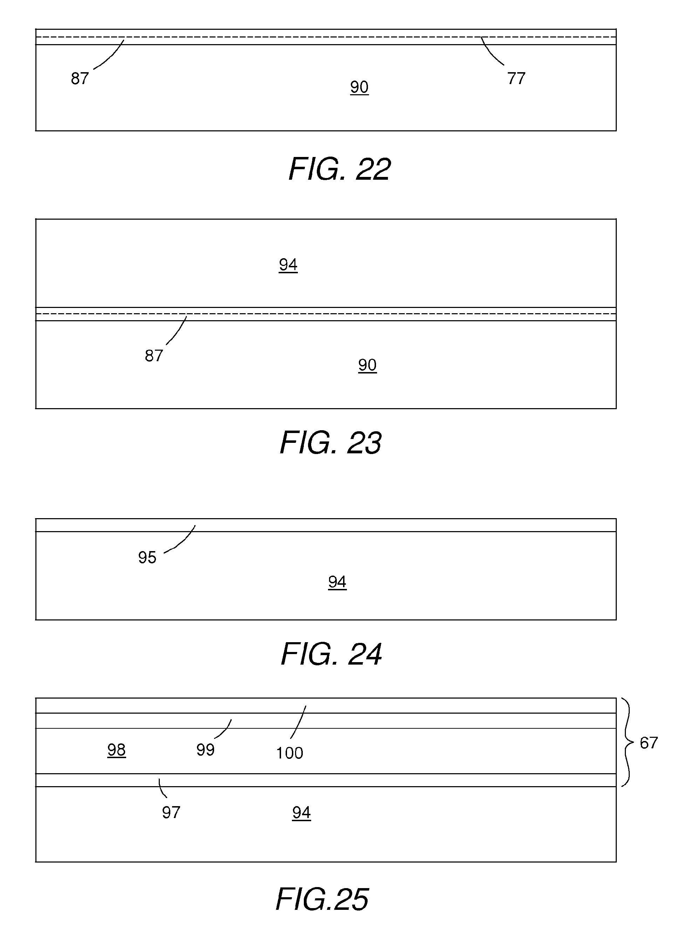

Referring to FIG. 10, a HEM structure of HEM layer 67 may be formed on the surface of substrate 61 such as formed on nucleation region 65. The material of layer 67 may be GaN or SiC or other III-N series or III-V series or II-VI series semiconductor material or a plurality of layers such as for example as described in the description of FIG. 25. In an embodiment, the material of layer 67 may be formed as an epitaxial layer such as by a depositional process using MBE or MOCVD, or similar techniques. It is believed that the insulator material of regions 64 does not have a fixed lattice structure which may facilitate region 65 absorbing at least a portion of the lattice strain thereby reducing the lattice stress applied to layer 67 such as for example stress between layer 67 and substrate 61. For example, reduce the lattice stresses at least near the surface of substrate 61. As illustrated in a general manner in FIG. 9, the insulator material of regions 64, such as silicon dioxide for example, is interspersed between silicon regions 63. The presence of the insulator allows for lattice mismatch accommodation. Layer 67 may be used to form HEM semiconductor devices or a plurality of HEM devices on substrate 61. For example HEM device elements may be formed on layer 67 such as for example the elements described for device 45 (FIG. 5).

FIG. 11 illustrates substrate 61 at a step of an alternate method of forming a HEM layer on silicon, such as for example on substrate 61. A silicon carbide (SiC) layer 69 may be formed on the surface of substrate 61 such as formed on nucleation region 65. Layer 67 may be formed on layer 69. The lattice structure of the material of layer 69 is closer to the lattice structure of layer 67 which reduces the lattice stress applied to layer 67.

FIG. 12 illustrates substrate 61 at a step of another alternate method of forming a HEM device on silicon, such as for example on substrate 61. An aluminum nitride (AlN) layer 73 may be formed on the surface of substrate 61 such as formed on nucleation region 65. SiC layer 69 may be formed on layer 73 and layer 67 may be formed on layer 69. Alternately, layer 69 may be omitted and layer 67 may be formed on layer 73.

Forming the HEM material, such as for example GaN or SiC or other III or II-V or II-VI series material, on a silicon substrate reduces the costs. Using a porous silicon substrate reduces the defects and stress thereby reducing the costs.

FIG. 13-FIG. 15 illustrate various stages in portions of an example of an embodiment of another method of forming HEM device such as a GaN or SiC semiconductor device or other III-N or III-V or II-VI series semiconductor device.

FIG. 13 illustrates a porous silicon (Si) substrate 70, such as for example a substrate similar to one of substrates 55 or 57 that was explained in the description of FIG. 7, and includes porous region 76. HEM layer or layers 67 may be formed on porous surface 76. The GaN or SiC or other III or II-V or II-VI series material can be formed on porous silicon with low lattice stress and high quality due to lattice accommodation. For example, it is believed that the pores may absorb some of the strain which reduces the lattice stress applied to layer 67. As will be seen further hereinafter, the strain may be reduced even further by subsequent steps of the method.

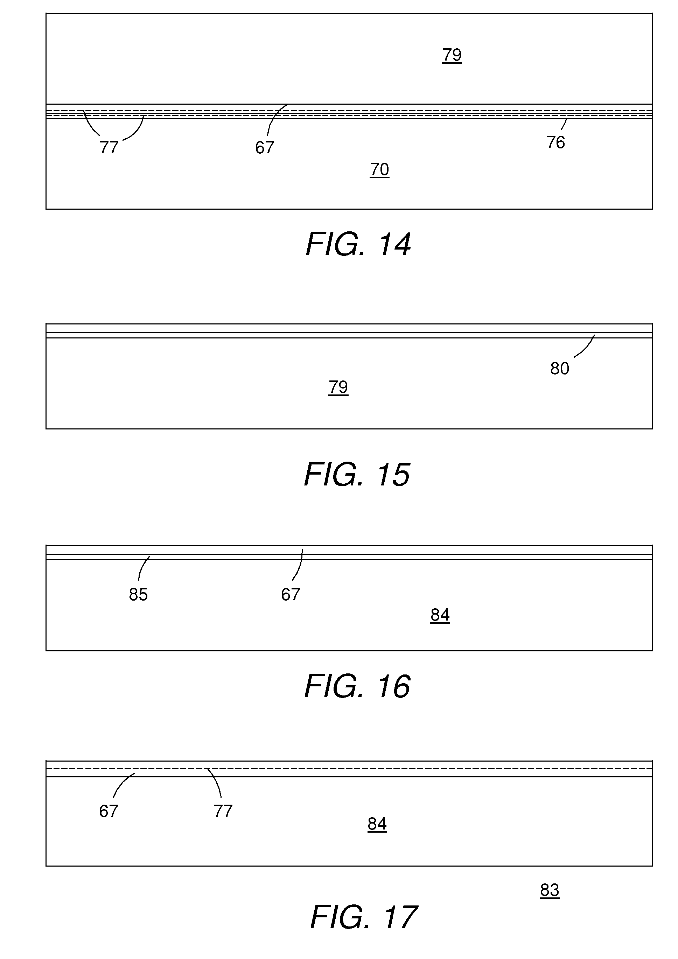

Referring to FIG. 14, a GaN device layer may be defined. For example, a friable region or layer 77, illustrated in general by a dashed line, may be created to assist in removing at least a portion of layer 67 from substrate 70. Region 77 may be formed in substrate 70 near the surface, such as in the surface of a bulk or epitaxial layer, or may be formed in layer 67 near the interface with substrate 70. Layer 77 may be formed by the diffusion or ion implantation of a light element such as hydrogen or helium at a high concentration distributed in a narrow band in the near-surface region of layer 67 of in the GaN layer. Alternately, friable region 77 may be formed in substrate 70 near the surface of substrate 70. Region 77 may be formed by various means including chemical or mechanical means. Region 77 will subsequently be used to remove at least a portion of layer 67 from substrate 70, such as remove a portion of layer 67 that extends substantially parallel to the surface of substrate 70 or along a long axis of layer 67.

A suitable intermediate substrate or carrier material or carrier substrate 79 may be bonded onto an opposite surface of layer 67, such as for example onto the GaN or SiC layer. In one example embodiment, substrate 79 includes a highly doped N-type layer (N+) of silicon. The N+ silicon may be a silicon wafer that is highly doped or may be a highly doped region or an epitaxial layer, such as an epitaxial layer on a bulk silicon or glass or ceramic substrate. In other embodiments, substrate 79 may be doped as P-type or may not be doped. Substrate 79 may also be SiC, GaAs, Al₂O₃, Ge, or some other semiconductor material. Since substrate 79 is bonded to layer 67, the lattice stress is minimized allowing the use of undoped or differently doped substrates.

Referring to FIG. 15, a thermal shock or other stress is applied to the bonded wafer pair, causing friable layer 77 to crack or separate and free at least a portion of the bonded material from the bulk of the original material. For example layer 67 may separate along a long axis that is substantially parallel to the surface of substrate 70. This leaves a portion of layer 67, such as for example a portion of the GaN or SiC layer, attached to substrate 79. In one embodiment, layer 77 separates to separate at least a portion layer 67 from substrate 70 such that a portion of layer 67 forms a layer 80 that is bonded onto substrate 79, and another portion of layer 67 remains attached to substrate 70. The portion of the layer 67, such as for example the portion of a GaN or SiC layer, having the most defects remains with the base substrate, such as with substrate 70, and is not a part of the resulting layer 80, such as for example GaN or SiC layer, on substrate 79, such as for example on the intermediate substrate. In the case that some silicon of substrate 70 may remain attached to layer 80, any remaining silicon may be removed from layer 80 easily due to etch selectivity. Additionally, layer 80, such as for example a GaN or SiC layer, may be transferred again, for example as explained in the description of FIGs. 22-23, to have the most efficient growth surface exposed for further epitaxial deposition and thickening of the layer(s) for device fabrication with low defect density. Layer 80 may be used to form HEM semiconductor devices on silicon substrate 79 as explained hereinbefore.

Also, substrate 70 may be re-used to grow additional GaN, SiC or other III-N or III-V or II-VI series semiconductor material. One example of such a method is described in the description of FIGs. 22-31.

The method results in a high quality GaN or SiC layer or other III-N or III-V or II-VI series semiconductor layer due to lattice accommodation of porous Si. The separating of layer 67 also assists in removing defects in layer 67 and improves the quality of the resulting GaN, SiC or other III-N or III-V or II-VI series semiconductor material. The method also provides for more precise thickness control. The resulting GaN or SiC other III-N or III-V or II-VI series layer has a high quality and a lower cost since it was formed on a silicon substrate. Additionally, process costs of wafer bonding are small compared to the costs of one time use of GaN or SiC substrates.

FIG. 16-FIG. 19 illustrate portions of various stages in portions of an example of an alternate embodiment of a method of forming HEM device including a GaN or SiC semiconductor device or other III-N series or III-V or II-VI series semiconductor device.

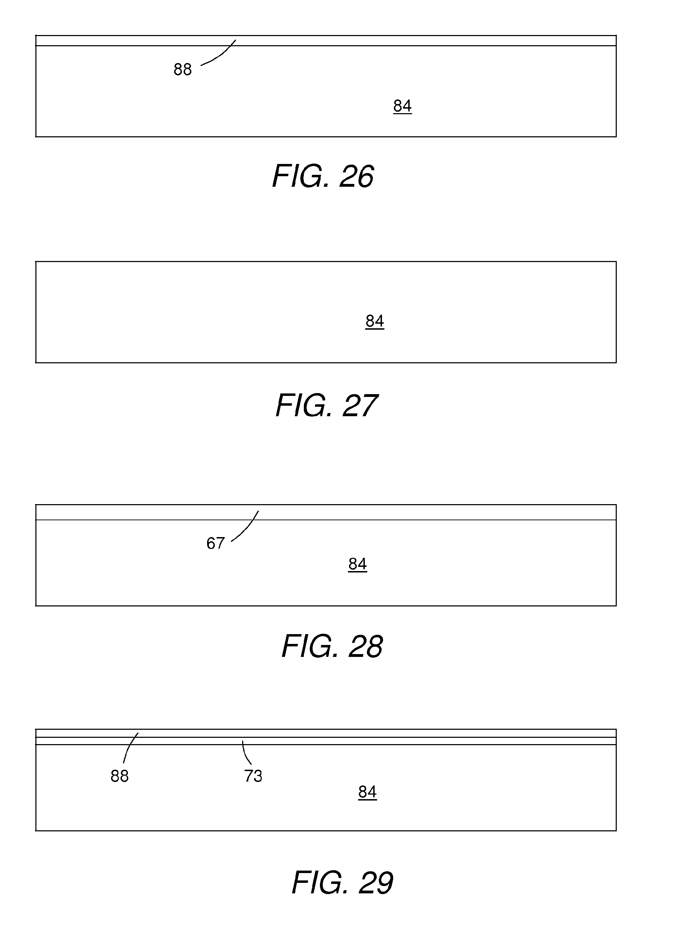

FIG. 16 illustrates a reduced cross-sectional view of an example of an embodiment of a portion of a silicon carbide (SiC) substrate 84. Layer 67 may be formed on a surface of substrate 84. It is believed that layer 67 has reduced defects because of the closer lattice match between the material of substrate 84 and layer 67. As will be seen further hereinafter, a portion of layer 67 may be removed and used to form a HEM device that has improved quality and reduced costs. In an alternate embodiment, an optional AlN layer 85 may be formed on the surface of substrate 84 prior to forming layer 67, such for example as described in the description of FIGs. 29-31, and layer 67 may be formed on layer 85.

Referring to FIG. 17, according to another step of the method, friable region 77 is formed in layer 67 or in substrate 84 near the surface thereof. In addition to SiC, substrate 84 may also be Si, GaAs, Al₂O₃, Ge, or some other semiconductor material.

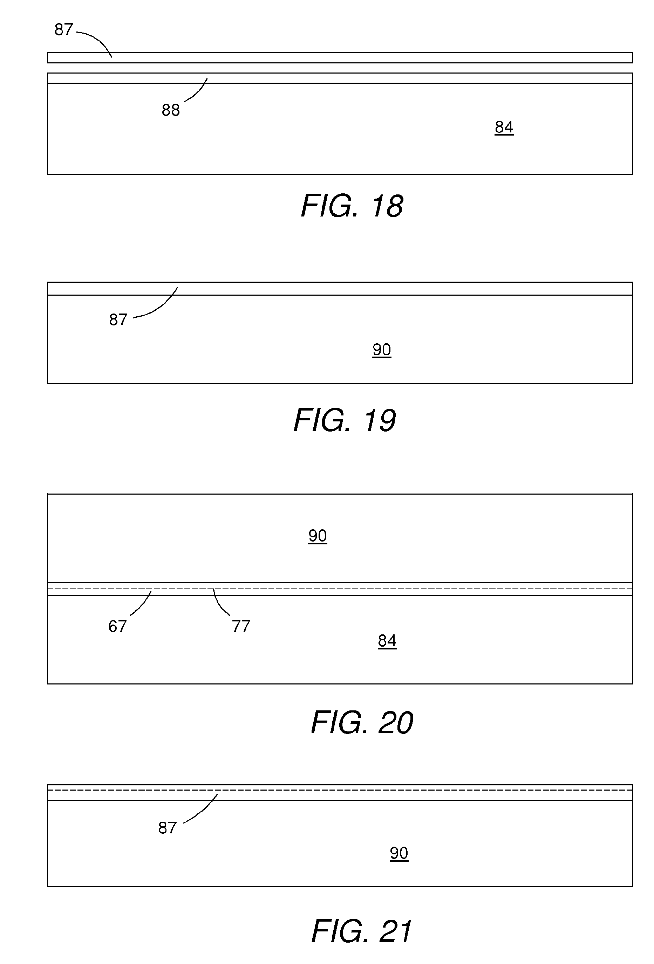

Referring to FIG. 18, a portion of layer 67, for example a portion of the III series material or GaN or SiC or other III-N or III-V or II-VI series semiconductor material for example, is removed along or near friable region 77. Separating friable region 77 may split layer 67 into two sections with a first section 88 remaining attached to substrate 84 as a layer 88 and a second section 87 separated from substrate 84.

Referring to FIG. 19, section 87 of layer 67, for example the removed layer, may be bonded to or attached to an intermediate substrate 90 and form a layer 87. Substrate 90 may be similar to substrate 79 (FIG. 14) as described herein before. Substrate 90 may also be SiC, GaAs, Al₂O₃, Ge, or some other semiconductor material. Layer 87 may be attached to substrate 90 using well known wafer bonding techniques. Layer 87 may be used to form HEM semiconductor devices, for example may be used to form a transistor or diode having elements similar to device 45 (FIG. 5).

FIG. 20-FIG. 21 illustrate various stages in portions of an example of another alternate embodiment of a method of forming a HEM device including a GaN or SiC or other III-N or III-V or II-VI series semiconductor device.

Referring to FIG. 20, a GaN or SiC or other III-N or III-V or II-VI series layer may be formed on a SiC base substrate. In one embodiment, layer 67 may be formed on substrate 84. Friable region 77 may be formed in layer 67 or substrate 84 as explained hereinbefore. For example, friable region 77 may be formed as explained hereinbefore, such as for example formed in the III series material that is formed on the SiC substrate. Silicon intermediate substrate 90 may be bonded onto the III series layer. In one embodiment, substrate 90 may be bonded onto layer 67.

Referring to FIG. 21, a portion of layer 67 may be removed from substrate 84 and remain bonded to substrate 90. For example a portion of the III series material or GaN for example, is removed along or near friable region 77. Region 77 may be separated to split layer 67 along a long axis such as for example approximately along a plane of the surface of substrate 84. A section 87 of layer 67 may be separated from substrate 84 and remain bonded to substrate 90. In one embodiment, layer 67, for example the III series material, is separated near or approximately along the friable region leaving a section of layer 67, or of the III series material, on the silicon intermediate substrate. In an embodiment, intermediate substrate 90 is preferably silicon (111), but can be other semiconductors and with selected polarity or crystal orientation and/or doping level.

HEM semiconductor devices may then be formed in layer 87 as described hereinbefore. In an embodiment, semiconductor device may be formed in the GaN or other III series layer.

FIG. 22-FIG. 25 illustrate various stages in portions of an example of another alternate embodiment of a method of forming a GaN or SiC or other III-N or III-V or II-VI series semiconductor device.

FIG. 22 starts at a stage after removing layer 87 from layer 67 using substrate 90, such as explained in the description of FIG. 18-19 or FIG. 20-21. An embodiment starts after removing a III series material layer (such as GaN for example) from a SiC base substrate using a Si intermediate substrate such as explained in the description of FIG. 19 or FIG. 21. Layer 87 may be attached to substrate 90 by wafer bonding using well known wafer bonding techniques or may be bonded using van Der Waals' force. Friable region 77 is formed in layer 87.

Referring to FIG. 23, in an embodiment another intermediate substrate 94 is attached to layer 87. In an embodiment, substrate 94 is similar to substrates 79 or 90 and is bonded to layer 87. An embodiment may include that the another intermediate substrate, such as a Si intermediate substrate, is bonded to the surface of a III series layer.

Referring to FIG. 24, friable layer 77 is separated to separate layer 87 substantially along a long axis that is approximately in a plane of the surface of substrate 90 leaving a portion of layer 87 attached to substrate 94 as a HEM layer 95. Another embodiment may include that the first intermediate substrate is removed leaving the III series layer on the second intermediate substrate. HEM semiconductor devices may be formed on layer 95, such as for example on the III series layer.

One advantage is that this embodiment enables use of the face of layer 95, such as for example the front face of the III series (such as the Ga face in GaN) layer, to be the front surface for high growth rate of additional GaN or SiC or other III-N or III-V or II-VI series layers such as for example additional epitaxial layers, such AlGaN (See FIG. 25 for example).

FIG. 25 illustrates another alternate embodiment of a method of forming HEM device including a GaN or SiC or other III series device or other III-N or III-V or II-VI series semiconductor device. In an embodiment, the III series layer may include a plurality of layers formed together. Any of layers 67 or 87 or 95 may include multiple layers. For example, an AlN layer 97 may be formed on substrate 94 or other hereinbefore explained substrates, such as for example the base substrate. A GaN layer 98 may be formed on AlN layer 97. An AlGaN layer 99 may be formed on GaN layer 98, and/or a GaN layer 100, or other III series material, may be formed on AlGaN layer 99.

In one example embodiment, the GaN can be approximately 0.1 to 10µm thick as a standalone layer or as portion of the total multilayer structure. AlN layer 97 may be approximately one nanometer to one thousand nanometers thick (1 nm to 1000 nm). GaN layer 98 may be approximately one tenth to ten microns thick (0.1 to 10µm). AlGaN layer 99 may be approximately two to one hundred nanometers thick (2 to 100nm), and GaN layer 100 may be approximately ten to one thousand nanometers thick (10 to 1000 nm).

FIG. 26-FIG. 28 illustrate various steps in portions of an example of another alternate embodiment of a method of forming a HEM semiconductor device including a GaN or SiC semiconductor device or other III series device or other III-N or III-V or II-VI series semiconductor device. In one embodiment, a substrate may be re-used for multiple numbers of sequences of forming devices.

FIG. 26 illustrates a step near a point after separating layer 67 and leaving a portion of layer 67 on wafer 84 as a layer 88, for example as described in the description of FIGs. 18-19. Substrate 84 may be re-used to form other HEM devices. An embodiment may include removing the remaining portions of layer 88 from substrate 84 and then re-using substrate 84. For example the method may include removing a III series material layer (such as GaN for example) from a SiC base substrate, for example removing the GaN layer using a silicon intermediate substrate such as explained in the description of FIG. 18 and the beginning of FIG. 19. The SiC base substrate may be reused for forming another III series layer.

As illustrated in FIGs. 26-27, layer 88 may be removed from substrate 84. For example, layer 88 may be removed such as by wet etching, or dry etching, or CMP or other polishing operations. An embodiment may include any remaining GaN may be removed from the surface of the base SiC substrate such as by wet etching, or dry etching, or CMP or other polishing operations.

FIG. 28 illustrates that substrate 84 may subsequently be reused to form another HEM semiconductor device. For example another layer 67 may be formed on substrate 84 to a part of the operations to form the next semiconductor device. An embodiment may include that the SiC base wafer, such as substrate 84 for example, may be re-used to form another GaN layer of other III series material layer.

FIG. 29-FIG. 31 illustrate various stages in portions of an example of another alternate embodiment of a method of forming HEM device including a GaN or SiC semiconductor device or other III series device or other III-N or III-V or II-VI series semiconductor device. The method includes an alternate method to re-use a substrate such as for example substrate 84.

Referring to FIG. 29, an AlN layer 73 may be formed on the surface of substrate 84. Substrate 84 may then be used to form HEM devices using techniques described hereinbefore, include as described in the description of FIGs. 16-25. After forming the HEM device, the operations typically leave at least a at least a residue of or a portion of layer 88 attached to AlN layer 73.

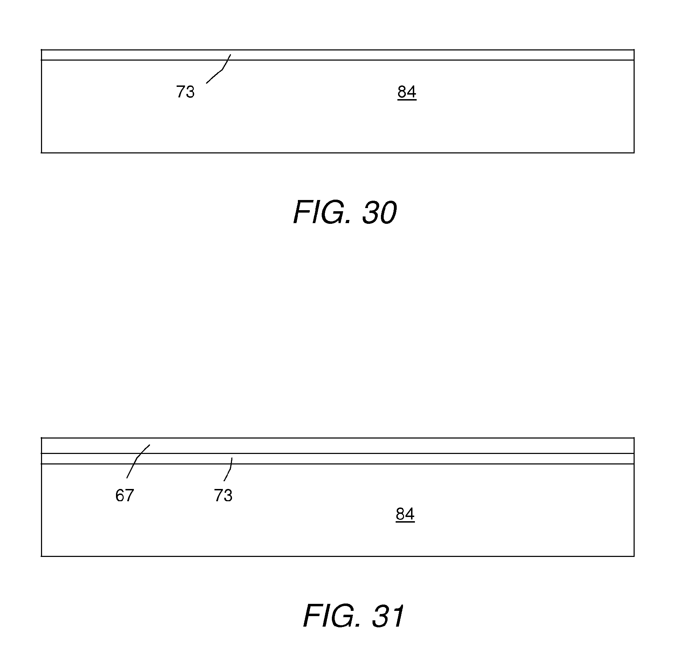

Referring to FIG. 30, an etching procedure may be used to remove the portion or residue of layer 88 that remain on layer 73. Layer 73 typically functions as an etch stop for such operations such that layer 73 is minimally affected by the etching operation. Thus, layer 73 functions as a selective etch stop. In an embodiment, the method includes a step of using a selective etch to stop at AlN layer 73.

Referring to FIG. 31, subsequently, substrate 84 and layer 73 may be re-used to form another HEM device. In an embodiment, SiC substrate 84 may be used with AlN layer 73 for forming additional GaN epi layers.

As can be seen from the foregoing, an embodiment may include that a high quality GaN on lattice-matched SiC, or GaN may be formed. An embodiment may include forming a high quality or SiC semiconductor device or other III series device or other III-N or III-V or II-VI series semiconductor device at a low cost by forming the HEM device on a silicon substrate. In an embodiment, the friable layer is created in the surface of a bulk or epitaxial layer by the diffusion or ion implantation of a light element such as hydrogen or helium at a high concentration distributed in a narrow band in the near-surface region of the GaN layer. This allows for layer separation by various means and reduces the amount of defective material. Removal of remaining GaN away from SiC may easily be done due to etch selectivity. Reuse of the same high cost SiC or GaN substrate for repeat devices provides significant cost reduction. The method results in a high quality of GaN/SiC, on low cost Si substrate, thereby enabling high performance-over-cost ratio. The additional process cost of wafer bonding are small compared to using one time GaN on SiC substrates. The same concept can be employed using GaAs, AlN, sapphire, or any expensive substrate.

From all the foregoing, one skilled in the art will appreciate that a method of forming a semiconductor device may comprise:
providing a base substrate of a first semiconductor material that includes silicon, such as for example a silicon substrate or a silicon carbide substrate; and
forming a layer that is one of GaN or SiC or other III-N or III-V or II-VI series material on the base substrate.

An embodiment of the method may include providing a porous silicon substrate, and forming nucleation sites on a porous surface of the porous silicon substrate.

Another embodiment of the method may include forming an insulator on the porous surface, and planarizing the insulator.

In an embodiment, the method may include forming the insulator as one of silicon oxide, silicon dioxide, silicon nitride, or aluminum nitride.

Those skilled in the art will further understand that a HEM device may comprise: a silicon base substrate having a surface in a (111) plane; and
a layer of GaN or other II-V or II-VI material on the surface of the silicon base substrate wherein the layer is formed with a (0001) plane on the (111) plane of the silicon base substrate.

Another embodiment may include that the HEM device includes a channel material on at least a portion of the layer.

In an embodiment, the channel material may include a layer of AlGaN.

An embodiment may include that the HEM device includes a gate material overlying the channel material.

Those skilled in the art will also understand that one embodiment of a method of forming a HEM device may comprise: providing a base substrate, such as for example one of substrates 70 or 84 or the like, of a first semiconductor material that includes silicon, for example a silicon substrate or a silicon carbide substrate;
forming a layer that is one of GaN or SiC or other III-N or III-V or II-VI series material overlying the base substrate;
forming a friable region near an interface of the layer and an underlying material;
separating a portion of the layer from the base substrate;
attaching the portion of the layer to an intermediate substrate; and
forming the HEM device in the portion of the layer.

An embodiment of the method may include separating the layer into two sections along a long axis of the layer that is substantially parallel to the surface of the base substrate.

Those skilled in the art will also understand that a method of forming a HEM device may comprise: providing a base substrate, such as for example one of substrates 70 or 84 or the like, of a first semiconductor material that includes silicon, for example a silicon substrate or a silicon carbide substrate or other material that includes silicon;
forming a layer that is one of GaN or SiC or other III-N or III-V or II-VI series material overlying the base substrate;
forming a friable region near an interface of the layer and an underlying material;
attaching an intermediate substrate to the layer, such as for example substrate 90;
separating a portion of the layer from the base substrate; and
forming the HEM device in the portion of the layer.

Those skilled in the art will further understand that a method of forming a HEM device may comprise: providing a base substrate of a first semiconductor material that includes silicon, for example a silicon substrate or a silicon carbide substrate; and
forming a layer that is one of GaN or SiC or other III-N or III-V or II-VI series material on the base substrate.

Another embodiment of the method may include providing the base substrate includes providing a porous silicon base substrate.

An embodiment of the method may include forming a friable region in the layer.

In an embodiment, the method may include bonding an intermediate substrate to the layer.

An embodiment may include separating the intermediate substrate and at least a portion of the layer from the base substrate.

Another embodiment may include separating at least a portion of the layer from the base substrate.

In an embodiment, the method may include bonding the portion of the layer to an intermediate substrate.

An embodiment may include cleaning the base substrate and forming another layer on the base substrate wherein the another layer is one of GaN or SiC or other III-N or III-V or II-VI series material.

One embodiment may include forming the HEM device that includes the layer.

In an embodiment, the method may include providing a porous silicon base substrate having pores on a surface of the base substrate; forming an insulator on and within the pores; and planarizing the surface to form silicon nucleation sites on the surface of the base substrate.

An embodiment may include forming a layer that includes a plurality of III series layers.

Another embodiment may include forming an AlN layer and forming a GaN layer on the AlN layer.

An embodiment may include providing a silicon base substrate having a surface in a (111) plane.

The method may also include forming a layer of GaN on the surface of the silicon base substrate wherein the GaN is formed with a (0001) plane on (111) plane of the silicon base substrate.

An embodiment may include providing a substrate that is one of silicon or silicon carbide.

Another embodiment may include providing a substrate that is one of SiC, GaAs, Al₂O₃, or Ge; forming the layer on the base substrate; forming a friable region in the layer and separating the friable region to separate at least a portion of the layer from the base substrate.

An embodiment may include removing residue of the layer from the base substrate, and forming another layer on the base substrate wherein the another layer is one of GaN or SiC or other III-N or III-V or II-VI series material on the base substrate.

While the subject matter of the descriptions are described with specific preferred embodiments and example embodiments, the foregoing drawings and descriptions thereof depict only typical and exemplary embodiments of the subject matter and are not therefore to be considered to be limiting of its scope, it is evident that many alternatives and variations will be apparent to those skilled in the art.

As the claims hereinafter reflect, inventive aspects may lie in less than all features of a single foregoing disclosed embodiment. Thus, the hereinafter expressed claims are hereby expressly incorporated into this Detailed Description of the Drawings, with each claim standing on its own as a separate embodiment of an invention. Furthermore, while some embodiments described herein include some but not other features included in other embodiments, combinations of features of different embodiments are meant to be within the scope of the invention, and form different embodiments, as would be understood by those skilled in the art.

## Claims

1. A method of forming a HEM device comprising:
providing a base substrate of a first semiconductor material that includes silicon;
forming a layer that is one of GaN or SiC or other III-N or III-V or II-VI series material overlying the base substrate;
forming a friable region near an interface of the layer and an underlying material;
separating a portion of the layer from the base substrate;
attaching the portion of the layer to an intermediate substrate; and
forming the HEM device in the portion of the layer.

2. The method of claim 1 wherein separating the portion of the layer includes separating the layer into two sections along a long axis of the layer that is substantially parallel to the surface of the base substrate.

3. The method of claim 1 further including attaching the intermediate substrate to the portion of the layer prior to separating the portion of the layer.

4. A method of forming a semiconductor device comprising:
providing a base substrate of a first semiconductor material that includes silicon; and
forming a layer that is one of GaN or SiC or other III-N or III-V or II-VI series material on the base substrate.

5. The method of claim 4 wherein providing the base substrate includes providing a porous silicon base substrate.

6. The method of claim 5 further including forming a friable region in the layer.

7. The method of claim 6 further including bonding an intermediate substrate to the layer.

8. The method of claim 6 further including separating at least a portion of the layer from the base substrate.

9. The method of claim 8 further including bonding the portion of the layer to an intermediate substrate.

10. The method of claim 9 further including cleaning the base substrate and forming another layer on the base substrate wherein the another layer is one of GaN or SiC or other III-N or III-V or II-VI series material.

11. The method of claim 4 wherein providing the base substrate includes providing a porous silicon base substrate having pores on a surface of the base substrate;
forming an insulator on and within the pores; and
planarizing the surface to form silicon nucleation sites on the surface of the base substrate.

12. The method of claim 4 wherein forming the layer includes forming an AlN layer and forming a GaN layer on the AlN layer.

13. A HEM device comprising:
a silicon base substrate having a surface in a (111) plane; and
a layer of GaN or other II-V or II-VI material on the surface of the silicon base substrate wherein the layer is formed with a (0001) plane on the (111) plane of the silicon base substrate.

14. The HEM device of claim 13 further including a channel material on at least a portion of the layer.

15. The HEM device of claim 14 wherein the channel material includes AlGaN.
